# EUROPEAN PATENT SPECIFICATION

(11) **EP 1 259 023 B1**
(45) Date of publication and mention of the grant of the patent: **24.08.2005**
(21) Application number: 01111694.4
(22) Date of filing: 14.05.2001
(51) Int. Cl.: H04L 7/033, H04H 1/00, H04L 25/49, H03L 7/095, H04L 27/233

(54) **RDS decoder**
RDS Dekoder
Décodeur de signaux RDS

(43) Date of publication of application: 20.11.2002
(73) Proprietor: Sony International (Europe) GmbH, 10785 Berlin (DE)
(72) Inventor: Wildhagen, Jens, c/oAdva. Techno. Center Stuttgart, 70327 Stuttgart (DE)
(74) Representative: Müller - Hoffmann & Partner

(56) References cited:
- EP-A- 0 195 989
- EP-A- 0 803 999
- GARDNER F M: "A BPSK/QPSK TIMING-ERROR DETECTOR FOR SAMPLED RECEIVERS" IEEE TRANSACTIONS ON COMMUNICATIONS, IEEE INC. NEW YORK, US, vol. 34, no. 5, 1 May 1986 (1986-05-01), pages 423-429, XP000608506 ISSN: 0090-6778

## Description

The present invention is directed to a method to perform a synchronization in a RDS decoder by synchronizing to zero crossings in received RDS data symbols and to a RDS decoder comprising a RDS time recovery loop working according to this principle.

In FM broadcast, the same program material is usually transmitted via different frequencies. Modern mobile FM broadcast receivers therefore check the alternative frequencies to switch to the frequency with the best reception. An alternative frequency list is transmitted in the RDS (Radio Data System) data stream.

In case the tuner finds an alternative frequency with a better reception, e. g. a higher fieldstrength and/or less distortions, the tuner needs to know whether the alternative frequency transmits the same program or whether the alternative frequency contains a different program. For this purpose the receiver decodes the RDS data stream of the alternative frequency and compares the content thereof with the previously decoded RDS data stream of the "currently tuned" frequency. Depending on the receiver strategy the receiver mutes during the time of checking the RDS data stream or switches to the audio signal of the alternative frequency. Both of these possibilities might annoy a listener, since the muting might be audible or a different signal might be audible in case the alternative frequency contains a different program. In both cases the distortions in the audio signal can be minimized by minimization of the time intervals to check the RDS data stream of the alternative frequency.

Since a not neglectable time is needed for the RDS time recovery loop to perform the time synchronization, it is the object underlying the present invention to provide an improved synchronization method and an improved RDS decoder which is able to work according to said method.

Further information pertaining to the prior art can be found in EP 0 195 989 which discloses a method of demodulating an input signal phase-modulated by a binary bit sequence and a circuit arrangement therefor, wherein, to demodulate a so-called RDS signal, latter is in each case sampled four times in a continuously repeating sampling cycle, the sampling times of each sampling cycle being defined by means of a sequence of rectangular pulses synchronized to the RDS signal, in such a manner that the samples are phase-shifted with respect to one another by in each case one quarter of the signal period and the first sample is approximately located at a null of the RDS signal. The successive even-numbered samples of all sampling cycles are compared with one another. In the case of inequality, the intermediate odd- numbered sample is checked for parity with one of the two even-numbered samples. The results of the check are added or subtracted in accordance with their parity and from the sum a synchronizing signal is derived for the sequence of rectangular pulses. In the case of equality of the compared even-numbered samples, it is determined whether these belong to a single sampling cycle or to successive sampling cycles. If the frequency of the check results identifying the sampling cycle identity exceeds a predetermined value, the sequence of rectangular pulses is phase-shifted by 180°. The bit sequence of the RDS information contained in the RDS signal is recovered from the even-numbered samples.

The method to perform a synchronization in a RDS decoder by synchronizing to zero crossings in received RDS data symbols according to the present invention is defined in independent claim 1. An RDS decoder which synchronizes to zero crossings in received RDS data symbols according to the present invention is defined in independent claim 6. Preferred embodiments thereof are respectively defined in the respective following dependent claims. A computer program product according to the present invention is defined in claim 11.

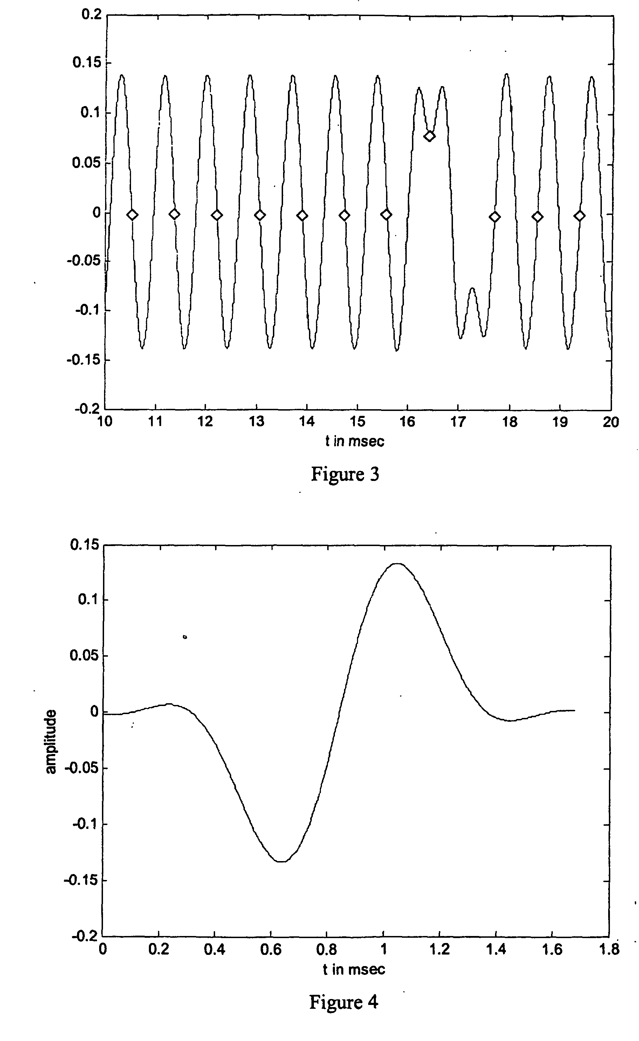

The RDS data symbols are bi-phase symbols, wherein one symbol consists of a positive and a negative part, as it is depicted in Fig. 4.

Usually, a time recovery loop synchronizes to the zero crossings of the RDS data symbol which is shown in Fig. 4 at approximately 0.9 msec, i.e. to the zero crossing in the middle of the data symbol. Once a zero crossing is found by the time recovery loop the next zero crossing gets searched after a time interval corresponding in length to one RDS data symbol, i.e after 0.842 msec.

To ensure a fast synchronization which leads to reduced distortions in the audio signals which are output by the receiver during the alternative frequency check, according to the present invention a verification is performed according to which it is determined whether a found zero crossing to which the RDS decoder synchronizes is likely to be correct or not, and the RDS decoder is synchronized to a following zero crossing which is non-linear shifted in respect to the found zero crossing in case the verification result shows that the found zero crossing is likely to be not correct.

In this case a non-linear shifting means that the next zero crossing is not searched after a time interval corresponding to one RDS data symbol, but around a point of time during said time interval or around a point of time which is periodic thereto in respect to the length of one RDS data symbol.

To verify whether a found zero crossing to which the RDS decoder synchronizes or is synchronized is likely to be correct or not, according to the present invention preferably the received RDS symbol comprising the zero crossing undergoing the verification gets sampled with at least two check samples, wherein the first check sample precedes the found zero crossing by a first predetermined distance and the second check sample succeeds the found zero crossing by a second predetermined distance, whereafter all check samples are added, the resulting sum is compared with a threshold, and in case the absolute value of the resulting sum lies above the threshold, it is determined that the found zero crossing is likely to be not correct.

Further preferably, the received RDS symbol is sampled with three check samples, wherein the third check sample corresponds to the found zero crossing.

Still further preferably, said first determined distance equals to said second predetermined distance.

To verify whether a found zero crossing to which the RDS decoder synchronizes or is synchronized is likely to be correct or not, according to the present invention additionally to the above verification method a received RDS symbol might be sampled with at least two check samples, wherein the first check sample corresponds to the found zero crossing and the second check sample corresponds to the expected other zero crossing of the received RDS symbol, both check samples are compared, and in case the absolute value of the check sample of the found zero crossing lies above absolute value of the check sample of the other zero crossing, it is determined that said found zero crossing is likely to be not correct.

The non-linear shift in respect to the found zero crossing according to the present invention is preferably performed by searching the next zero crossing about a time of 0.5 or n+0.5 RDS symbols after the found zero crossing, wherein n is a positive integer.

Since according to the present invention a faster correct synchronization in comparison to the time needed for a correct synchronization according to the prior art can be assured, the audible distortions during checking of the alternative frequency are minimized. Further, the RDS data stream can be evaluated faster, which e. g. leads to a faster display of the station name also during the normal operation.

The features and advantages of the present invention will become more apparent from the following detailed description of an exemplary embodiment thereof taken in conjunction with the accompanying Figures, wherein
- **Fig. 1**: shows a RDS data symbol wherein check samples according to the present invention are indicated;
- **Fig. 2**: shows a RDS signal comprising several RDS data symbols including the zero crossings that are used for the synchronization according to the present invention in case the RDS decoder is synchronized correctly from the beginning;
- **Fig. 3**: shows a RDS signal comprising several RDS data symbols including the zero crossings that are used for the synchronization according to the present invention in case the RDS decoder was first synchronized to the wrong zero crossing;
- **Fig. 4**: shows one RDS data symbol;
- **Fig. 5**: shows an exemplary RDS signal comprising several RDS data symbols; and
- **Fig. 6**: shows the zero crossings that are used for the synchronization by a state of the art RDS decoder that is first synchronized to the wrong zero crossings.

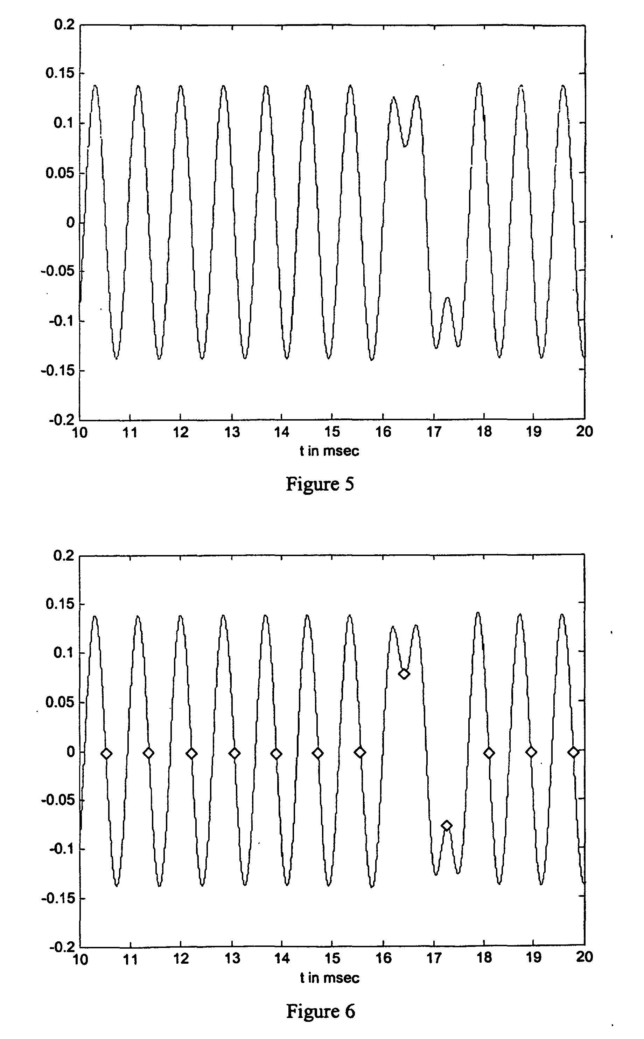

An exemplary RDS data symbol is shown in Fig. 4. An exemplary RDS signal comprising several RDS data symbols is shown in Fig. 5. From the time t of 10 to 16 msec all RDS data symbols are regularly and therefore a sinus-like signal with regular positive and negative amplitudes comprising approximately 7 RDS data symbols in this period is shown. After the point of time t = 16 msec two irregular RDS data symbols are shown whereafter from the point of time t = 17.7 msec, the regular RDS data symbols which are shown from 10 to 16 msec are continued.

A state of the art RDS decoder looks for the first zero crossing it finds and then synchronizes to it by looking for following zero crossings approximately after a period of time corresponding to the length of one RDS data symbol. Since the RDS data symbols are bi-phase symbols which are regularly transmitted, each of these symbols basically consists of two zero crossings. Therefore, it is possible that - depending on the transmitted data - the time recovery loop might synchronize to the wrong zero crossings.

Fig. 6 shows such a case for a state of the art RDS decoder. Fig. 6 shows the same signal as depicted in Fig. 5, but the zero crossings that are used for synchronization are additionally depicted by diamonds. Since in the time interval from 10 to 16 msec the RDS signal is regular, the correct zero crossings, which are the zero crossings not indicated by diamonds, cannot be distinguished by the time recovery loop from the wrong zero crossings, which are indicated by diamonds, and to which the RDS decoder is synchronized in this example. The RDS decoder detects the last regular zero crossing at approximately 15.4 msec and thereafter searches the next zero crossing at 16.3 msec and obtains an amplitude value of approximately 0,1. One RDS data symbol later an amplitude value of approximately -0.1 is obtained, whereafter in a respective distance of one RDS data symbol an amplitude of approximately 0 is followingly obtained, since the RDS data symbols are again regularly from 17.7 msec on.

As stated above, in the time interval from 10 to 16 msec, the time recovery loop does not realize that the synchronization is wrong, since all amplitude values obtained during this periode at the found zero crossing are zero. The values obtained at times 16.4 msec and 17.3 msec contain high absolute values. Depending on the design of the recovery loop and the transmitted data the recovery loop does not realize that it is wrongly synchronized, since only two values are different from zero. Also, in case wrong synchronization is recognized, a long time to synchronize again to the correct zero crossings is needed, since the high values of the zero crossing signal at times 16.4 msec and 17.3 msec are integrated in the loop filter of the recovery loop to an overall value of 0 which increases the problem of synchronization to the wrong zero crossing.

In contrast thereto the RDS decoder according to the present invention comprises a recovery loop which allows a non-linear operation to quickly synchronize to the correct zero crossings in case an error is detected.

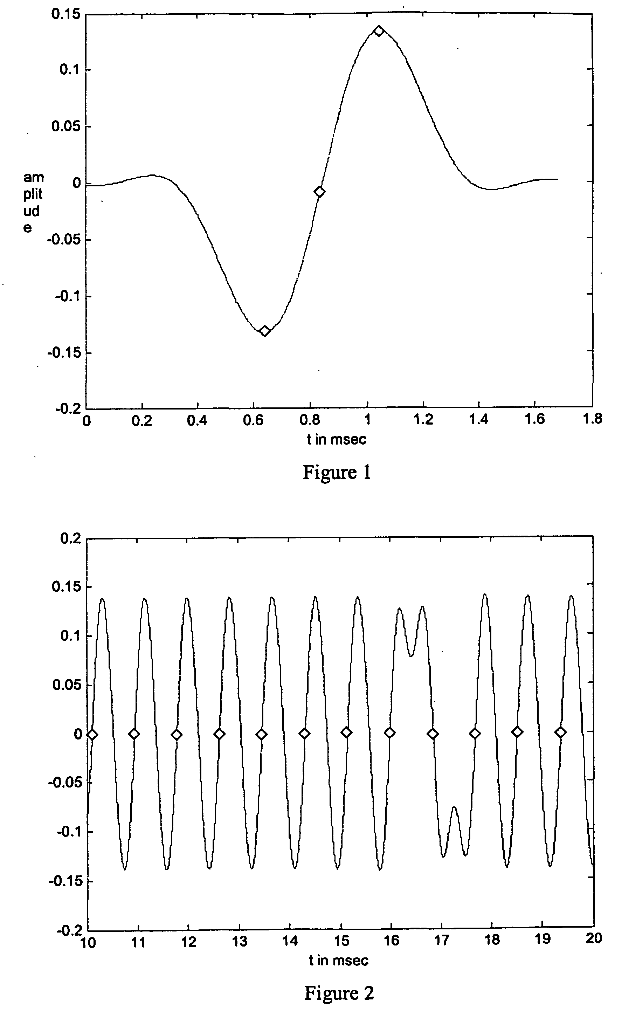

According to the exemplary described preferred embodiment of the present invention described in the following, each RDS symbol is sampled with three samples, as it is shown in Fig. 1 by diamonds for the sampled values within one RDS data symbol, which RDS data symbol corresponds to that depicted in Fig. 4.

The recovery loop in general basically operates like a state of the art recovery loop, except the fact that all three samples depicted in Fig. 1 are added and the resulting sum is compared to a threshold to verify the correctness of the found zero crossing. The samples depicted in Fig. 1 are a first sample approximately 1/4 RDS data symbol before the found zero crossing, the second sample approximately 1/4 RDS data symbol after the found zero crossing and the third sample at the found zero crossing. As mentioned before, the sum of all these three samples is then compared with a threshold. In case of a correct synchronization, the sum of all three samples is almost zero all the time due to the bi-phase structure of the RDS data symbols in case the time difference of the first to the third sample equals to that of the third to the second sample. In case the above-mentioned sum exceeds the threshold value, the recovery loop performs a non-linear shift of the sampling time of the next expected zero crossing which is used for the synchronization, i.e. one RDS data symbol length after the found zero crossing, to the next correct zero crossing or a zero crossing succeeding the next correct zero crossing one or more RDS data symbol lengths.

Fig. 2 depicts the zero crossings that are sampled in case the RDS decoder is synchronized correctly from the beginning of the signal, which signal is also shown in Fig. 5. The sampled zero crossings begin with the first zero crossing after t = 10 msec and a next sampled zero crossing, respectively, after a length of RDS data symbol.

In this case the RDS recovery loop works similar to that of a state of the art RDS decoder.

Fig. 3 depicts the zero crossings that are sampled by the RDS decoder according to the present invention in case the decoder is first synchronized to the wrong zero crossings for the same signal as shown in Fig. 5, i. e. shows a case comparable to that shown and described in connection with Fig. 6.

The samples of the zero crossings from 10 to 16 msec are identical to those depicted in Fig. 6. However, the sum of all check samples at the time t = 16.4 msec contains a very high value. Therefore, the sum of the three samples allows to distinguish easily between a correct synchronization and a synchronization to the wrong zero crossing and the recovery loop according to the present invention performs a non-linear shift of the sampling time to the next zero crossing. The zero crossing sampling time is shifted from t = 16.3 msec to t = 17.7 msec in one step. Alternatively, a shifting to t = 16.8 msec or more than one RDS data symbol lengths after this time would also be possible.

As mentioned before, instead of using all three check samples, only the two check samples before and after the found zero crossing might be used to distinguish between a correct synchronization and a synchronization to the wrong zero crossing.

Additionally to the above described comparison of the two or three check samples to a threshold, it is also possible to compare the check sample of the found zero crossing to a check sample of the expected other zero crossing of the RDS data symbol to perform a non-linear shift of the sampling time to the next zero crossing in case the value of the check sample of the found zero crossing shows a higher absolute value than that of the check sample of the expected other zero crossing. In this case, basically a comparison of the sampling values shown in Figures 2 and 6 is performed to verify whether the synchronization is correct or not. Due to noise which might be included in the signal a comparison of one check sample to a threshold to distinguish between a correct synchronization and a synchronization to the wrong zero crossing is not advantageous.

Thereafter, the next zero crossings are again looked for after the length of one RDS data symbol.

Therewith, a RDS decoder for FM broadcast is described which allows a fast synchronization of the RDS decoder's time recovery loop. The fast synchronization of the RDS time recovery loop leads to decreased distortions in the audio signal in mobile single tuner FM radios which check alternative frequencies. To realize the fast synchronization it is verified whether a found zero crossing to which the RDS decoder synchronizes or is synchronized is likely to be correct or not and the RDS decoder gets synchronized to a following zero crossing which is a non-linear shifted in respect to the found zero crossing in case the verification shows that the found zero crossing is likely to be not correct.

## Claims

1. Method for performing a time synchronization in a RDS decoder by synchronizing to zero crossings in received RDS data symbols, comprising the steps of:
verifying whether a found zero crossing to which said RDS decoder synchronizes or is synchronized is likely to be correct or not, and
synchronizing said RDS decoder to a following zero crossing which is non-linear shifted in respect to said found zero crossing in case said verification shows that said found zero crossing is likely to be not correct, wherein said non-linear shifting constitutes searching for said following zero crossing not after a time interval corresponding to one RDS data symbol, but around a point of time during said interval or around a point of time that is periodic thereto with respect to the length of one RDS data symbol, and
sampling a received RDS symbol with at least two check samples,
**characterized by** the steps of:
adding all check samples of said received RDS symbol,
comparing the resulting sum with a threshold, and
determining that said found zero crossing is likely to be not correct if the absolute value of said resulting sum lies above said threshold, wherein
a first check sample of said at least two check samples precedes said found zero crossing by a first predetermined distance and a second check sample of said at least two check samples succeeds said found zero crossing by a second predetermined distance.

2. Method according to claim 1, comprising the step of:
sampling said received RDS symbol with three check samples, wherein said third check sample corresponds to said found zero crossing.

3. Method according to claim 1 or 2, wherein
said first predetermined distance equals said second predetermined distance.

4. Method according to claim 1, comprising the steps of:
sampling a received RDS symbol with at least two additional check samples, wherein a first additional check sample of said at least two additional check samples corresponds to said found zero crossing and a second additional check sample of said at least two additional check samples corresponds to the expected other zero crossing of said received RDS symbol,
comparing said first and second additional check samples, and
determining that said found zero crossing is likely to be not correct if the absolute value of said first additional check sample lies above the absolute value of said second additional check sample.

5. Method according to anyone of claims 1 to 4, wherein
said following zero crossing is set 0.5 or n+0.5 RDS symbols after said found zero crossing, wherein n is a positive integer.

6. RDS decoder for synchronizing to zero crossings in received RDS data symbols, comprising:
a verification unit configured and adapted for determining whether a found zero crossing to which said RDS decoder synchronizes is likely to be correct or not;
a synchronization shifting unit configured and adapted for synchronizing said RDS decoder to a following zero crossing that is non-linear shifted with respect to said found zero crossing in case said verification unit determines that said found zero crossing is likely to be not correct, wherein said non-linear shifting constitutes searching for said following zero crossing not after a time interval corresponding to one RDS data symbol, but around a point of time during said interval or around a point of time that is periodic thereto with respect to the length of one RDS data symbol; and
a check sample unit configured and adapted for determining at least two check samples of a received RDS symbol;
**characterized by**
an adder configured and adapted for adding all check samples of said received RDS symbol; and
a comparator configured and adapted for comparing the resulting sum with a threshold, wherein
said verification unit is configured and adapted for determining said found zero crossing as likely to be not correct if the absolute value of said resulting sum lies above said threshold, and
a first check sample of said at least two check samples precedes said found zero crossing by a first predetermined distance and a second check sample of said at least two check samples succeeds said found zero crossing by a second predetermined distance.

7. RDS decoder according to claim 6, wherein
said check sample unit is configured and adapted for determining three check samples of said received RDS symbol, wherein the third check sample corresponds to the assumed correct zero crossing.

8. RDS decoder according to claim 7, wherein
said first predetermined distance equals said second predetermined distance.

9. RDS decoder according to claim 6, wherein
said check sample unit is configured and adapted for determining at least two additional check samples, wherein a first additional check sample of said at least two additional check samples corresponds to said found zero crossing and a second additional check sample of said at least two additional check samples corresponds to the expected other zero crossing of said received RDS symbol, and
said verification unit is configured and adapted for determining that said found zero crossing is likely to be not correct if the absolute value of said first additional check sample lies above the absolute value of said second additional check sample, said RDS decoder comprising:
a comparator configured and adapted for comparing said first and second additional check samples.

10. RDS decoder according to anyone of claims 6 to 9, wherein
said following zero crossing is set 0.5 or 1.5 RDS symbols after the assumed correct zero crossing.

11. Computer program product, comprising computer program means adapted to carry out the method steps as defined in anyone of claims 1 to 5 when said computer program product is executed on a computer, digital signal processor or the like.

## Patentansprüche

1. Verfahren zur Zeitsynchronisation in einem RDS Decoder durch Synchronisieren auf Nulldurchgänge von empfangenen Datensymbolen mit den Schritten:
Überprüfen ob ein ermittelter Nulldurchgang, auf den der RDS Decoder synchronisiert oder synchronisiert wird, voraussichtlich zutreffend ist oder nicht, und
Synchronisieren des RDS Decoders auf einen nachfolgenden Nulldurchgang, welcher nicht linear bezüglich des ermittelten Nulldurchgangs verschoben ist im Falle, dass die Überprüfung ergibt, dass der ermittelte Nulldurchgang voraussichtlich nicht zutreffend ist, wobei die nicht lineare Verschiebung ein Suchen nach dem nachfolgenden Nulldurchgang nicht nach einem Datensymbol entsprechenden Zeitintervall, sondern um einen Zeitpunkt während des Intervalls oder um einen hierzu um die Länge eines RDS Datensymbols periodischen Zeitpunkts einschließt, und
Abtasten eines empfangenen RDS Symbols mit wenigstens zwei Prüf-Abtastwerten,
**charakterisiert durch** die Schritte:
Addieren aller Prüf-Abtastwerte des empfangenen RDS Symbols,
Vergleichen der Ergebnissumme mit einem Schwellwert, und
Festlegen, dass der ermittelte Nulldurchgang voraussichtlich nicht zutreffend ist, falls der Absolutwert der Ergebnissumme oberhalb des Schwellwerts liegt, wobei
ein erster Prüf-Abtastwert der wenigstens zwei Prüf-Abtastwerte dem ermittelten Nulldurchgang um einen ersten bestimmten Abstand vorausgeht und ein zweiter Prüf-Abtastwert der wenigstens zwei Prüf-Abtastwerte dem ermittelten Nulldurchgang um einen zweiten bestimmten Abstand nachfolgt.

2. Verfahren nach Anspruch 1 mit dem Schritt:
Abtasten des empfangenen RDS Symbols mit drei Prüf-Abtastwerten, wobei der dritte Prüf-Abtastwert dem ermittelten Nulldurchgang entspricht.

3. Verfahren nach Anspruch 1 oder 2, wobei
der erste bestimmte Abstand mit dem zweiten bestimmten Abstand übereinstimmt.

4. Verfahren nach Anspruch 1 mit den Schritten:
Abtasten eines empfangenen RDS Symbols mit wenigstens zwei zusätzlichen Prüf-Abtastwerten, wobei ein erster zusätzlicher Prüf-Abtastwert der wenigstens zwei zusätzlichen Prüf-Abtastwerte dem ermittelten Nulldurchgang entspricht und ein zweiter zusätzlicher Prüf-Abtastwert der wenigstens zwei zusätzlichen Prüf-Abtastwerte dem erwarteten weiteren Nulldurchgang des empfangenen RDS Symbols entspricht,
Vergleichen der ersten und zweiten zusätzlichen Prüf-Abtastwerte, und
Festlegen, dass der ermittelte Nulldurchgang voraussichtlich nicht zutreffend ist, falls der Absolutwert des ersten zusätzlichen Prüf-Abtastwerts oberhalb des Absolutwerts des zweiten zusätzlichen Prüf-Abtastwerts liegt.

5. Verfahren nach einem der Ansprüche 1 bis 4, wobei
der nachfolgende Nulldurchgang um 0,5 oder n+0.5 RDS Datensymbole nach dem ermittelten Nulldurchgang festgelegt wird, wobei n eine positive ganze Zahl ist.

6. RDS Decoder zum Synchronisieren auf Nulldurchgänge in RDS Datensymbolen mit:
einer Überprüfungseinrichtung, die konfiguriert und geeignet ist zum Festlegen, ob ein ermittelter Nulldurchgang, auf den der RDS Decoder synchronisiert, voraussichtlich zutreffend ist oder nicht;
einer Synchronisations-Verschiebungseinrichtung, die konfiguriert und geeignet ist zum Synchronisieren des RDS Decoders auf einen nachfolgenden nicht linear bezüglich des ermittelten Nulldurchgangs verschobenen Nulldurchgang im Falle, dass die Überprüfungseinrichtung festlegt, dass der ermittelte Nulldurchgang voraussichtlich nicht zutreffend ist, wobei die nicht lineare Verschiebung ein Suchen des nachfolgenden Nulldurchgangs nicht nach einem Datensymbol entsprechenden Zeitintervall, sondern um einen Zeitpunkt während des Intervalls oder um einen hierzu um die Länge eines RDS Datensymbols periodischen Zeitpunkt einschließt, und
einer Prüf-Abtastwert-Einrichtung , die konfiguriert und geeignet ist zum Festlegen von wenigstens zwei Prüf-Abtastwerten eines empfangenen RDS Datensymbols,
**charakterisiert durch**
einen Addierer, der konfiguriert und geeignet ist zum Addieren aller Prüf-Abtastwerte des empfangenen RDS Symbols, und
einen Komparator, der konfiguriert und geeignet ist zum Vergleichen der Ergebnissumme mit einem Schwellwert, wobei
die Überprüfungseinrichtung konfiguriert und geeignet ist zum Festlegen, dass der ermittelte Nulldurchgang voraussichtlich nicht zutreffend ist, falls der Absolutwert der Ergebnissumme oberhalb des Schwellwerts liegt, und
einen dem ermittelten Nulldurchgang um einen ersten bestimmten Abstand vorausgehenden ersten Prüf-Abtastwert der wenigstens zwei Prüf-Abtastwerte und einen dem ermittelten Nulldurchgang um einen zweiten bestimmten Abstand nachfolgenden zweiten Prüf-Abtastwert der wenigstens zwei Prüf-Abtastwerte.

7. RDS Decoder nach Anspruch 6, wobei
die Prüf-Abtastwert-Einrichtung konfiguriert und geeignet ist zum Festlegen von drei Prüf-Abtastwerten des empfangenen RDS Symbols, wobei der dritte Prüf-Abtastwert dem angenommenen zutreffenden Nulldurchgang entspricht.

8. RDS Decoder nach Anspruch 7, wobei
der erste bestimmte Abstand dem zweiten bestimmten Abstand entspricht.

9. RDS Decoder nach Anspruch 6, wobei
die Prüf-Abtastwert-Einrichtung konfiguriert und geeignet ist zum Festlegen von wenigstens zwei zusätzlichen Prüf-Abtastwerten, wobei ein erster Prüf-Abtastwert der wenigstens zwei zusätzlichen Prüf-Abtastwerte dem ermittelten Nulldurchgang entspricht und ein zweiter Prüf-Abtastwert der wenigstens zwei Prüf-Abtastwerte dem erwarteten weiteren Nulldurchgang des empfangenen RDS Datensymbols entspricht, und
die Überprüfungseinrichtung konfiguriert und geeignet ist zum Festlegen, dass der ermittelte Nulldurchgang voraussichtlich nicht zutreffend ist, falls der Absolutwert des ersten zusätzlichen Prüf-Abtastwerts oberhalb des Absolutwerts des zweiten zusätzlichen Prüf-Abtastwerts liegt, und der Decoder aufweist:
einen Komparator, der konfiguriert und geeignet ist zum Vergleichen der ersten und zweiten zusätzlichen Prüf-Abtastwerte.

10. RDS Decoder nach einem der Ansprüche 6 bis 9, wobei
der nachfolgende Nulldurchgang um 0,5 oder 1,5 RDS Symbole nach dem angenommenen Nulldurchgang festgelegt wird.

11. Computerprogramm-Produkt mit einer Computerprogramm-Vorrichtung zum Ausführen der Verfahrensschritte nach einem der Ansprüche 1 bis 5 beim Ausführen des Computer-Programms auf einem Computer, digitalen Signalprozessor oder desgleichen.

## Revendications

1. Procédé pour réaliser une synchronisation dans le temps d'un décodeur RDS par synchronisation sur des passages par zéro dans des symboles reçus de données RDS, comprenant les étapes consistant à:
vérifier si un passage par zéro trouvé, sur lequel ledit décodeur RDS se synchronise ou est synchronisé, est susceptible d'être correct ou non, et
synchroniser ledit décodeur RDS sur un passage par zéro suivant, qui est décalé de façon non linéaire par rapport audit passage par zéro trouvé dans le cas où ladite vérification montre que ledit passage par zéro trouvé est susceptible de ne pas être correct, ledit décalage non linéaire constituant une recherche dudit passage par zéro suivant non pas au bout d'un intervalle de temps correspondant à un symbole de données RDS, mais autour d'un instant au cours dudit intervalle ou autour d'un instant qui est périodique par rapport à cet instant, en rapport avec la longueur d'un symbole de données RDS, et
échantillonner un symbole RDS reçu avec au moins deux échantillons de contrôle,
**caractérisé par** les étapes consistant à:
ajouter tous les échantillons de contrôle dudit symbole RDS reçu,
comparer la somme résultante à un seuil, et
déterminer que ledit passage par zéro trouvé est susceptible de ne pas être correct si la valeur absolue de ladite somme résultante est supérieure audit seuil,
un premier échantillon de contrôle dudit au moins deux échantillons de contrôle précédant ledit passage par zéro, d'une première distance prédéterminée, et un second échantillon de contrôle parmi lesdits au moins deux échantillons de contrôle succédant audit passage par zéro trouvé, et ce d'une distance prédéterminée.

2. Procédé selon la revendication 1, comprenant l'étape consistant à:
échantillonner ledit symbole RDS reçu avec trois échantillons de contrôle, ledit troisième échantillon de contrôle correspondant audit passage par zéro trouvé.

3. Procédé selon la revendication 1 ou 2, selon lequel:
ladite première distance prédéterminée est égale à ladite seconde distance prédéterminée.

4. Procédé selon la revendication 1, comprenant les étapes consistant à:
échantillonner un symbole RDS reçu avec au moins deux échantillons de contrôle additionnels, un premier échantillon de contrôle additionnel parmi lesdits au moins deux échantillons de contrôle additionnels correspondant audit passage par zéro trouvé et un second échantillon de contrôle additionnel desdits au moins deux échantillons de contrôle additionnels correspondant à l'autre passage par zéro attendu dudit symbole RDS reçu,
comparer lesdits premier et second échantillons de contrôle additionnels, et
déterminer que ledit passage par zéro trouvé est susceptible de ne pas être correct si la valeur absolue dudit premier échantillon de contrôle additionnel est supérieure à la valeur absolue dudit second échantillon de contrôle additionnel.

5. Procédé selon l'une des revendications 1 à 4, dans lequel
ledit passage par zéro suivant est réglé sur 0,5 ou n + 0,5 symboles RDS après ledit passage par zéro trouvé, n étant un entier positif.

6. Décodeur RDS pour la synchronisation de passage par zéro dans les symboles de données RDS reçus, comprenant:
une unité de vérification configurée et adaptée pour déterminer si un passage par zéro trouvé, sur lequel ledit décodeur RDS se synchronise, est susceptible d'être correct ou non;
une unité de décalage de synchronisation configurée et adaptée pour synchroniser ledit décodeur RDS sur un passage par zéro suivant, qui est décalé de façon non linéaire par rapport audit passage par zéro trouvé dans le cas où ladite unité de vérification détermine que ledit passage par zéro trouvé est susceptible de ne pas être correct, ledit décalage non linéaire constituant une recherche dudit passage par zéro suivant non pas au bout d'un intervalle de temps correspondant à un symbole de données RDS, mais autour d'un instant au cours dudit intervalle ou autour d'un instant qui est périodique par rapport à cet instant, en rapport avec la longueur d'un symbole de données RDS; et
une unité de formation d'échantillons de contrôle configurée et adaptée pour déterminer au moins deux échantillons de contrôle d'un symbole RDS reçu;
**caractérisé par**
un additionneur configuré et adapté pour additionner tous les échantillons de contrôle dudit symbole RDS reçu; et
un comparateur configuré et adapté pour comparer la somme résultante à un seuil, dans lequel
ladite unité de vérification configurée et adaptée pour déterminer ledit passage par zéro trouvé comme étant susceptible de ne pas être correct si la valeur absolue de la distance résultante est supérieure audit seuil;
un premier échantillon de contrôle parmi lesdits au moins deux échantillons de contrôle précède ledit passage par zéro trouvé, d'une première distance prédéterminée et un second échantillon de contrôle parmi lesdits au moins deux échantillons de contrôle succède audit passage par zéro trouvé, à une seconde distance prédéterminée.

7. Décodeur RDS selon la revendication 6, dans lequel
ladite unité de production d'échantillons de contrôle est configurée et adaptée pour déterminer trois échantillons de contrôle dudit symbole RDS reçu, le troisième échantillon de contrôle correspondant au passage par zéro correct supposé.

8. Décodeur RDS selon la revendication 7, dans lequel
ladite première distance prédéterminée est égale à ladite seconde distance prédéterminée.

9. Décodeur RDS selon la revendication 6, dans lequel
ladite unité de production d'échantillons de contrôle est configurée et adaptée pour déterminer au moins deux échantillons de contrôle additionnels, dans lequel un premier échantillon de contrôle additionnel parmi lesdits au moins deux échantillons de contrôle additionnels correspond audit passage par zéro trouvé et un second échantillon de contrôle additionnel parmi lesdits deux échantillons de contrôle additionnels correspond à l'autre passage par zéro attendu dudit symbole RDS reçu, et
ladite unité de vérification est configurée et adaptée pour établir que ledit passage par zéro trouvé est susceptible de ne pas être correct si la valeur absolue dudit premier échantillon de contrôle additionnel est supérieure à la valeur absolue dudit second échantillon de contrôle additionnel, ledit décodeur RDS comprenant:
un comparateur configuré et adapté pour comparer lesdits premier et second échantillons de contrôle additionnels.

10. Décodeur RDS selon l'une quelconque des revendications 6 à 9, dans lequel
ledit passage par zéro suivant est réglé sur 0,5 ou 1,5 symbole RDS après le passage par zéro correct supposé.

11. Produit de programme informatique comprenant des moyens de programme informatique adaptés pour exécuter les étapes de procédé telles que définies dans l'une quelconque des revendications 1 à 5, lorsque ledit produit de programme informatique est mis en oeuvre dans un ordinateur, un processeur de signaux numériques ou analogue.
